# EUROPEAN PATENT APPLICATION

(11) **EP 4 618 150 A2**
(43) Date of publication of application: **17.09.2025**
(21) Application number: 25162944.0
(22) Date of filing: 11.03.2025
(51) Int. Cl.: H01L 23/538

(54) **SEMICONDUCTOR PACKAGE DEVICE AND METHOD OF MANUFACTURING THE SAME**

(30) Priority: 15.03.2024 KR 20240036123; 17.02.2025 KR 20250019883
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a semiconductor package device and a method of manufacturing the same. The semiconductor package device includes a plurality of chiplet substrate units disposed spaced apart from each other or adjacent to each other, each of the chiplet substrate units having a plurality of via-type wiring elements, each of the chiplet substrate units including at least one of one or more passive device elements and one or more active device elements, a molding layer configured to form a single substrate shape along with the chiplet substrate units while filling spaces between and around the chiplet substrate units and to expose the chiplet substrate units, a redistribution layer member disposed on a first surface of a package substrate including the chiplet substrate units and the molding layer, and a plurality of chips mounted on the redistribution layer member so as to be electrically connected to the redistribution layer member.

## Description

### CROSS-REFERENCE TO RELATED APPLICATIONS

This application claims priority to Korean Patent Application No. 10-2024-0036123, filed on March 15, 2024, and Korean Patent Application No. 10-2025-0019883, filed on February 17, 2025, the entire contents of which are herein incorporated by reference.

### BACKGROUND OF THE INVENTION

### 1. Field of the invention

The present invention relates to semiconductor package-related technology and methods, and more particularly to a substrate for semiconductor packages, a semiconductor package device including the substrate, and a method of manufacturing the same.

### 2. Description of the Related Art

A semiconductor process may be divided into a front-end process of manufacturing a wafer and engraving a circuit and a back-end process of packaging a chip. As semiconductor miniaturization technology approaches its limits, importance of the back-end process is further increasing. In this regard, advanced packaging technology that integrates different semiconductor chips or vertically connects a plurality of chips to each other is emerging as important technology. Recently developed artificial intelligence (AI) and high-performance computing (HPC) products may be constituted by a system-on-chip (SoC) such as a high bandwidth memory (HBM), a central processing unit (CPU), a neural processing unit (NPU), and a graphics processing unit (GPU).

2.5-dimensional (2.5D) packaging is packaging technology that integrates a plurality of semiconductor chips (dies) into a single package after horizontally disposing the plurality of semiconductor chips. 2.5D packaging is different from 3D packaging in that each chip is disposed on an interposer, which is a packaging part. A logic chip and a memory chip may be horizontally disposed on the interposer. Connecting chips through interconnect technology may improve connectivity between the chips.

Chip-on-wafer-on-substrate (CoWoS), a type of 2.5D packaging technology, means that two or more semiconductor chips are interconnected on a wafer and then placed on a package substrate. The memory chip and the logic chip may be horizontally mounted on the interposer or may be vertically stacked on the interposer. In order to implement CoWoS, interposer (e.g., silicon interposer) technology that connects a plurality of chips like a single die is primarily used. The interposer is a type of substrate, but is characterized by only routing signals without any logic functions.

The interposer uses a through silicon via (TSV) or a through mold via (TMV) for electrical connection, and have a configuration that increases the ball pitch. In addition, in most cases, the interposer is used for interconnection of heterogeneous chips at the wafer level. However, all of these methods and processes have the disadvantages of being low in productivity, inefficient, and relatively high in production cost. In addition, 2.5D packaging technology using the conventional interposer has the limitations of being difficult to respond to various design changes and difficult to improve performance.

### SUMMARY OF THE INVENTION

It is an object of the present invention to provide a semiconductor package device capable of increasing cost-effectiveness and productivity and improving device performance and a method of manufacturing the same.

It is another object of the present invention to provide a semiconductor package device that is easy to apply to various designs according to the needs and purposes of users, easy to manufacture, and beneficial for improving performance and a method of manufacturing the same.

The objects of the present invention are not limited to the above objects, and other unmentioned objects will be understood by those skilled in the art based on the following description.

In accordance with one aspect of the present invention, the above and other objects can be accomplished by the provision of a semiconductor package device including a plurality of chiplet substrate units having different configurations and characteristics, the plurality of chiplet substrate units being disposed spaced apart from each other or adjacent to each other in a horizontal direction, each of the plurality of chiplet substrate units having a plurality of via-type wiring elements extending in a vertical direction, each of the plurality of chiplet substrate units including at least one of one or more passive device elements and one or more active device elements, a molding layer configured to form a single substrate shape along with the plurality of chiplet substrate units while filling spaces between and around the plurality of chiplet substrate units and to expose the plurality of chiplet substrate units, a redistribution layer member disposed on a first surface of a package substrate including the plurality of chiplet substrate units and the molding layer, and a plurality of chips mounted on the redistribution layer member so as to be electrically connected to the redistribution layer member.

The plurality of chiplet substrate units may include a first chiplet substrate unit and a second chiplet substrate unit, and the first chiplet substrate unit and the second chiplet substrate unit may include different substrate materials or may have different circuit configurations.

The first chiplet substrate unit may include an inorganic substrate, and the second chiplet substrate unit may include an organic substrate.

The plurality of chiplet substrate units may further include one or more additional chiplet substrate units having different configurations from the first chiplet substrate unit and the second chiplet substrate unit.

The plurality of chiplet substrate units may include a first chiplet substrate unit and a second chiplet substrate unit, the first chiplet substrate unit may include at least one embedded passive device element and at least one embedded active device element, and the second chiplet substrate unit may include at least one embedded passive device element and at least one embedded active device element.

A plurality of bumps may be provided on one surface of each of the plurality of chips, and the plurality of chips may be mounted on the redistribution layer member such that the plurality of bumps is electrically connected to the redistribution layer member.

The plurality of chips may include heterogeneous chips.

A plurality of electrical connection elements may be disposed on a second surface of the package substrate, the second surface being opposite the first surface.

Each of the plurality of electrical connection elements may include a solder ball or a bump.

In accordance with another aspect of the present invention, there is provided a method of manufacturing a semiconductor package device, the method including providing a plurality of chiplet substrate units having different configurations and characteristics, each of the plurality of chiplet substrate units having a plurality of via-type wiring elements extending in a vertical direction, each of the plurality of chiplet substrate units including at least one of one or more passive device elements and one or more active device elements, the plurality of chiplet substrate units being provided in plural in order to constitute a plurality of sets of chiplet substrate units, disposing the plurality of chiplet substrate units on a carrier substrate, the plurality of chiplet substrate units being disposed spaced apart from each other or adjacent to each other in a horizontal direction in each of a plurality of two-dimensionally disposed unit package areas, forming a molding layer configured to form a single substrate shape along with the plurality of chiplet substrate units while filling spaces between and around the plurality of chiplet substrate units on the carrier substrate, forming a redistribution layer member on a first surface of a package substrate including the plurality of chiplet substrate units and the molding layer, mounting a plurality of chips on the redistribution layer member so as to be electrically connected to the redistribution layer member in each of the plurality of unit package areas, and dividing a device structure including the plurality of chiplet substrate units, the molding layer, the redistribution layer member, and the plurality of chips, with the carrier substrate being excluded, into individual package devices corresponding to each of the plurality of unit package areas.

The plurality of chiplet substrate units may include a first chiplet substrate unit and a second chiplet substrate unit, and the first chiplet substrate unit and the second chiplet substrate unit may include different substrate materials or may have different circuit configurations.

The first chiplet substrate unit may include an inorganic substrate, and the second chiplet substrate unit may include an organic substrate.

The plurality of chiplet substrate units may further include one or more additional chiplet substrate units having different configurations from the first chiplet substrate unit and the second chiplet substrate unit.

The plurality of chiplet substrate units may include a first chiplet substrate unit and a second chiplet substrate unit, the first chiplet substrate unit may include at least one embedded passive device element and at least one embedded active device element, and the second chiplet substrate unit may include at least one embedded passive device element and at least one embedded active device element.

A plurality of bumps may be provided on one surface of each of the plurality of chips, and the plurality of chips may be mounted on the redistribution layer member such that the plurality of bumps is electrically connected to the redistribution layer member.

The plurality of chips may include heterogeneous chips.

The method may further include forming a plurality of electrical connection elements on a second surface of the package substrate in each of the plurality of unit package areas, the second surface being opposite the first surface.

Each of the plurality of electrical connection elements may include a solder ball or a bump.

The method may further include removing the carrier substrate from the plurality of chiplet substrate units and the molding layer between the step of forming the molding layer and the step of dividing the device structure into the individual package devices.

The method may further include forming an initial molding layer configured to cover the plurality of chiplet substrate units and performing a grinding or ablation process on the initial molding layer to expose one surface of each of the plurality of chiplet substrate units.

### BRIEF DESCRIPTION OF THE DRAWINGS

FIG. 1 is a sectional view illustratively showing a semiconductor package device according to an embodiment of the present invention;
FIG. 2 is a sectional view illustratively describing a first chiplet substrate unit that can be applied to the semiconductor package device according to the embodiment of the present invention;
FIG. 3 is a sectional view illustratively describing a second chiplet substrate unit that can be applied to the semiconductor package device according to the embodiment of the present invention;
FIG. 4 is a plan view illustratively showing the planar structure of a package substrate that can be applied to the semiconductor package device according to the embodiment of the present invention;
FIGs. 5A to 5F are sectional views illustratively showing a method of manufacturing a semiconductor package device according to an embodiment of the present invention;
FIG. 6 is a plan view illustratively showing the planar structure of a carrier substrate and a plurality of chiplet substrate units that can be applied to the method of manufacturing the semiconductor package device according to the embodiment of the present invention; and
FIGs. 7A to 7D are sectional views illustratively showing a method of manufacturing a semiconductor package device according to another embodiment of the present invention.

### DETAILED DESCRIPTION OF THE PREFERRED EMBODIMENTS

Hereinafter, embodiments of the present invention will be described in detail with reference to the accompanying drawings.

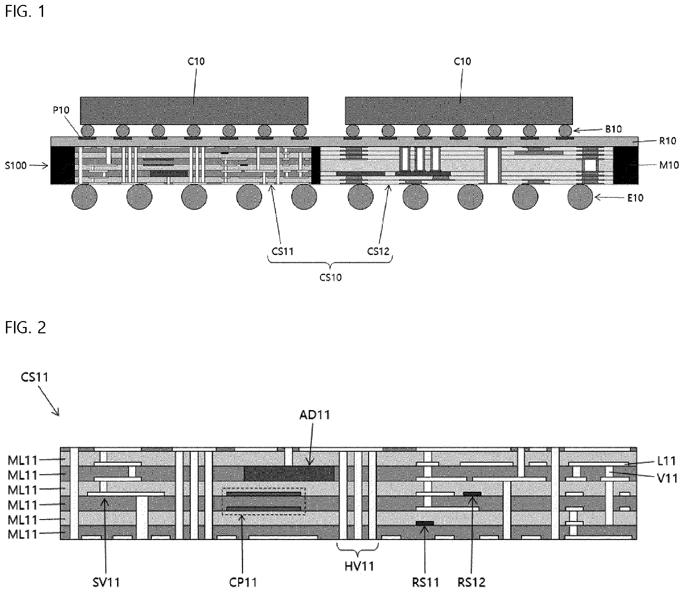

FIG. 1 is a sectional view illustratively showing a semiconductor package device according to an embodiment of the present invention.

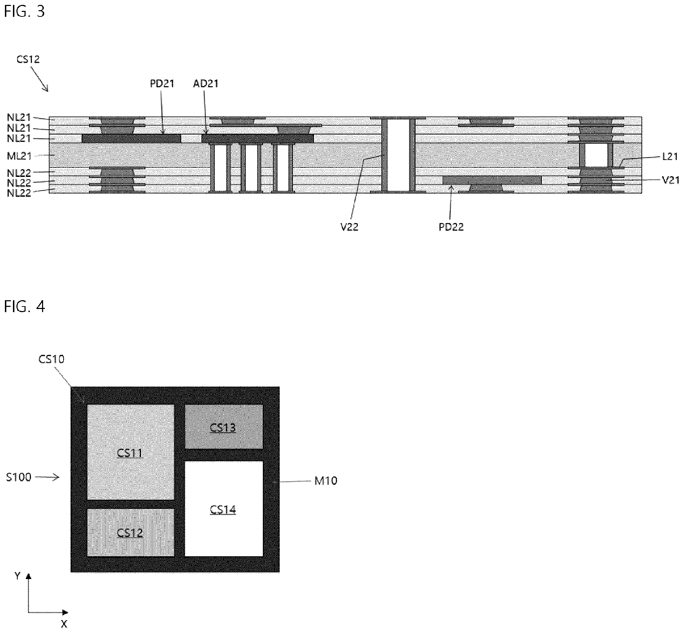

Referring to FIG. 1, the semiconductor package device according to the embodiment of the present invention may include a plurality of chiplet substrate units CS10 having different configurations and characteristics. The plurality of chiplet substrate units CS10 may have different functions, and may be disposed spaced apart from each other or adjacent to each other in a horizontal direction. The plurality of chiplet substrate units CS10 may be referred to as "circuit substrate units" or "integrated circuit substrate units." Each of the plurality of chiplet substrate units CS10 may have a plurality of via-type wiring elements extending in a vertical direction, and may include at least one of one or more passive device elements and one or more active device elements. The plurality of chiplet substrate units CS10 may include first and second chiplet substrate units CS11 and CS12 having different configurations/characteristics. The first and second chiplet substrate units CS11 and CS12 will be described in more detail later with reference to FIGs. 2 and 3.

The semiconductor package device may include a molding layer M10 that forms a single substrate shape along with the plurality of chiplet substrate units CS10 while filling the spaces between and around the plurality of chiplet substrate units CS10. The molding layer M10 may be configured to expose the plurality of chiplet substrate units CS10. For example, the molding layer M10 may expose upper surfaces and lower surfaces of the plurality of chiplet substrate units CS10. The molding layer M10 may have the same thickness or substantially the same thickness as the plurality of chiplet substrate units CS10, and may serve to fix the plurality of chiplet substrate units CS10 while wrapping around the plurality of chiplet substrate units CS10. The molding layer M10 may include a polymer material. For example, the molding layer M10 may include a molding compound.

The plurality of chiplet substrate units CS10 and the molding layer M10 may constitute a single package substrate S100. In other words, the package substrate S100 may include a plurality of chiplet substrate units CS10 and a molding layer M10.

The semiconductor package device may include a redistribution layer (RDL) member R10 disposed on a first surface of the package substrate S100. The first surface of the package substrate S100 may be any one of two main surfaces (an upper surface and a lower surface) of the package substrate S100. The redistribution layer member R10 may serve to redistribute an electrode pad array of the plurality of chiplet substrate units CS10. The redistribution layer member R10 may be formed through processes such as forming an insulating layer having a via hole (opening), forming a seed layer, forming a mask pattern, electroplating a wiring layer, and removing the mask pattern. Although the redistribution layer member R10 is simply shown in FIG. 1, the redistribution layer member R10 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The conductive via element may also be referred to as a "via-type wire" or a "via plug."

The redistribution layer member R10 may include a plurality of electrode pads P10 exposed on the surface thereof. The plurality of electrode pads P10 may be disposed on the opposite side of the package substrate S100, and may be disposed in two dimensions. The plurality of electrode pads P10 may be electrically connected to the plurality of chiplet substrate units CS10.

The semiconductor package device may include a plurality of chips C10 mounted on the redistribution layer member R10 so as to be electrically connected to the redistribution layer member R10. The plurality of chips C10 may be semiconductor chips, and may also be referred to as dies. According to an example, a plurality of bumps B10 may be provided on one surface of each of the plurality of chips C10. In other words, each of the plurality of chips C10 may include a plurality of bumps B10 disposed on one surface thereof. Each of the plurality of bumps B10 may be a micro bump, and may have at least a partial ball shape or other shapes. Each of the plurality of bumps B10 may be a type of electrical connection element. The plurality of chips C10 may be mounted on the redistribution layer member R10 such that the plurality of bumps B10 is electrically connected to the redistribution layer member R10. As the plurality of bumps B10 is connected to the plurality of electrode pads P10, the chip C10 may be electrically connected to the chiplet substrate unit CS10 via the redistribution layer member R10.

According to an embodiment, the plurality of chips C10 may include heterogeneous chips. For example, the plurality of chips C10 may include a memory chip and a logic chip, and may further include other types of chips. The plurality of chips C10 may be disposed on the redistribution layer member R10 so as to be spaced apart from each other in the horizontal direction, and in some cases, one or more chips (i.e., dies) may be further stacked (mounted) on at least one of the plurality of chips C10. In the semiconductor package device according to the embodiment of the present invention, the package substrate S100 having the redistribution layer member R10 formed thereon may be a semiconductor package substrate having an interposer function, and may be used for a 2.5D package or a 3D package. According to the embodiment of the present invention, the heterogeneous chips may be easily connected to each other.

The semiconductor package device may further include a plurality of electrical connection elements E10 disposed on a second surface of the package substrate S100, which is opposite the first surface of the package substrate S100. Here, the second surface of the package substrate S100 may be any one of the two main surfaces (the upper surface and the lower surface) of the package substrate S100. The plurality of electrical connection elements E10 may be disposed so as to be electrically connected to or to be in electrical contact with the plurality of chiplet substrate units CS10. As a non-limiting example, each of the plurality of electrical connection elements E10 may include a solder ball or a bump. The plurality of electrical connection elements E10 may be connected to a predetermined circuit board (e.g., a motherboard).

According to the embodiment of the present invention, the plurality of chiplet substrate units CS10 having different configurations and characteristics (functions) may be physically coupled to each other using the molding layer M10 to constitute a single package substrate S100, the redistribution layer member R10 may be formed on the package substrate S100, and the plurality of chips C10 may be mounted on the redistribution layer member R10. The plurality of chiplet substrate units CS10 may include two or more chiplet substrate units. The plurality of chips C10 may also include two or more chips. The plurality of chips C10 may be mounted, for example, using a flip-chip method. According to the embodiment of the present invention described above, it is possible to easily manufacture a semiconductor package substrate having a function of interconnecting the plurality of chips C10 and to improve the performance of the device, the degree of design freedom, and ease of design change using the plurality of chiplet substrate units CS10 having different configurations and characteristics. In this regard, according to the embodiment of the present invention, it is possible to implement a semiconductor package device capable of increasing cost-effectiveness and productivity and improving device performance and a method of manufacturing the same. In addition, according to the embodiment of the present invention, it is possible to provide a semiconductor package device that is easy to apply to various designs according to the needs and purposes of users, easy to manufacture, and beneficial for improving performance and a method of manufacturing the same.

According to an embodiment, the first and second chiplet substrate units CS11 and CS12 may include different substrate materials or have different circuit configurations. As a specific example, the first chiplet substrate unit CS11 may include an inorganic substrate, and the second chiplet substrate unit CS12 may include an organic substrate (polymer substrate). The inorganic substrate may be a ceramic substrate or a semiconductor substrate. For example, the semiconductor substrate may include any one of a silicon (Si) substrate, a germanium (Ge) substrate, and a silicon germanium (SiGe) substrate, or may include other semiconductor materials. According to another example, the first chiplet substrate unit CS11 may include a first inorganic substrate, and the second chiplet substrate unit CS12 may include a second inorganic substrate, which is different from the first inorganic substrate. Alternatively, the first chiplet substrate unit CS11 may include a first organic substrate, and the second chiplet substrate unit CS12 may include a second organic substrate, which is different from the first organic substrate.

The first chiplet substrate unit CS11 may include at least one embedded passive device element and/or at least one embedded active device element. The first chiplet substrate unit CS11 may include both at least one embedded passive device element and at least one embedded active device element. The second chiplet substrate unit CS12 may include at least one embedded passive device element and/or at least one embedded active device element. The second chiplet substrate unit CS12 may include both at least one embedded passive device element and at least one embedded active device element. As a non-limiting example, the passive device element may include a capacitor, a resistor, an inductor, and an integrated passive device (IPD). As a non-limiting example, the active device element may include a transistor, a diode, an operational amplifier, and an integrated circuit (IC). Both general passive and active devices used in semiconductor devices may be employed. The plurality of chiplet substrate units CS10 may be premanufactured according to circuit board manufacturing technology.

Although the case where the plurality of chiplet substrate units CS10 includes the first and second chiplet substrate units CS11 and CS12 is shown in FIG. 1, the plurality of chiplet substrate units CS10 may further include one or more additional chiplet substrate units having different configurations/characteristics from the first and second chiplet substrate units CS11 and CS12.

FIG. 2 is a sectional view illustratively describing the first chiplet substrate unit CS11 that can be applied to the semiconductor package device according to the embodiment of the present invention.

Referring to FIG. 2, the first chiplet substrate unit CS11 may be a first type of chiplet substrate. The first chiplet substrate unit CS11 may be an inorganic substrate-based chiplet substrate. The inorganic substrate may be a ceramic substrate or a semiconductor substrate. For example, the semiconductor substrate may include any one of a silicon (Si) substrate, a germanium (Ge) substrate, and a silicon germanium (SiGe) substrate, or may include other semiconductor materials.

The first chiplet substrate unit CS11 may include a plurality of stacked material layers ML11. The plurality of material layers ML11 may form a single stack. At least one of the plurality of material layers ML11 may include a ceramic material or a semiconductor material. Here, the ceramic material may be a material other than semiconductor materials such as Si, Ge, and SiGe. The plurality of material layers ML11 may be made of the same material, and at least two of the plurality of material layers ML11 may be made of different materials.

When stacking the plurality of material layers ML11, via elements V11 may be formed in the material layers, and pattern layer elements L11 may be formed between the material layers. The via elements V11 may be conductive via elements, and the pattern layer elements L11 may be conductive pattern layer elements. The plurality of via elements V11 and the plurality of pattern layer elements L11 may constitute various types of wiring. The first chiplet substrate unit CS11 may have a plurality of via-type wiring elements extending in a vertical direction. The plurality of via-type wiring elements may be in a form that interconnects a lower surface and an upper surface of the first chiplet substrate unit CS11.

The first chiplet substrate unit CS11 may include at least one embedded passive device element CP11, RS11, and RS12 and at least one embedded active device element AD11. The passive device element may include, for example, a capacitor CP11 and resistors RS11 and RS12. In addition, the first chiplet substrate unit CS11 may include at least one of a staggered via SV11, a thermal via HV11, a stacked via, a blind via, and a buried via. In addition, the first chiplet substrate unit CS11 may include a through silicon via (TSV) or a via element (electrode) equivalent thereto. The performance of the semiconductor package element may be improved by the configuration of the first chiplet substrate unit CS11. However, the specific configuration of the first chiplet substrate unit CS11 shown in FIG. 2 is only illustrative and may be varied in various ways.

FIG. 3 is a sectional view illustratively describing the second chiplet substrate unit CS12 that can be applied to the semiconductor package device according to the embodiment of the present invention.

Referring to FIG. 3, the second chiplet substrate unit CS12 may be a second type of chiplet substrate. The second chiplet substrate unit CS12 may be an organic substrate-based chiplet substrate. The organic substrate may include a polymer (plastic) material. The organic substrate may be, for example, made of a material having a low dielectric constant (low k) and a low coefficient of thermal expansion (low CTE); however, the embodiment of the present invention is not limited thereto.

The second chiplet substrate unit CS12 may include a core material layer (intermediate material layer) ML21, and the core material layer ML21 may correspond to an organic substrate. One or more first material layers NL21 may be stacked on one surface of the core material layer ML21, and one or more second material layers NL22 may be stacked on the other surface of the core material layer ML21. The first material layer NL21 and the second material layer NL22 may be organic material layers.

When stacking one or more first material layers NL21 and one or more second material layers NL22 on the core material layer ML21, and via elements V21 may be formed in the first material layers and the second material layers, and pattern layer elements L21 may be formed between the first material layers and the second material layers. The via elements V21 may be conductive via elements, and the pattern layer elements L21 may be conductive pattern layer elements. The plurality of via elements V21 and the plurality of pattern layer elements L21 may constitute various types of wiring. In addition, a via element V22 may be formed through the core material layer ML21 or the second chiplet substrate unit CS12. The second chiplet substrate unit CS12 may be provided with a plurality of via-type wiring elements extending in the vertical direction. The plurality of via-type wiring elements may be in a form that interconnects a lower surface and an upper surface of the second chiplet substrate unit CS12.

The second chiplet substrate unit CS12 may include at least one embedded passive device element PD21 and PD22 and at least one embedded active device element AD21. The passive device element PD21 and PD22 may include, for example, any one of a capacitor, a resistor, and an inductor. The passive device element PD21 and PD22 may include at least one integrated passive device (IPD). In addition, the second chiplet substrate unit CS12 may further include at least one of a micro via, a plated through hole (PTH), a blind via, a buried via, and a thermal via. The performance of the semiconductor package device may be improved by the configuration of the second chiplet substrate unit CS12. However, the specific configuration of the second chiplet substrate unit CS12 shown in FIG. 3 is only illustrative and may be varied in various ways.

FIG. 4 is a plan view illustratively showing the planar structure of the package substrate S100 that can be applied to the semiconductor package device according to the embodiment of the present invention.

Referring to FIG. 4, the package substrate S100 that can be applied to the semiconductor package device according to the embodiment of the present invention may include a plurality of chiplet substrate units CS10 disposed spaced apart from each other or adjacent to each other in the horizontal direction and a molding layer M10 that forms a single substrate shape along with the plurality of chiplet substrate units CS10 while filling the spaces between and around the plurality of chiplet substrate units CS10. The plurality of chiplet substrate units CS10 may have different configurations and characteristics. In this regard, at least two of the plurality of chiplet substrate units CS10 may include different substrate materials or have different circuit configurations. The plurality of chiplet substrate units CS10 may include, for example, first to fourth chiplet substrate units CS11, CS12, CS13, and CS14. The first to fourth chiplet substrate units CS11, CS12, CS13, and CS14 may have different configurations and characteristics. The molding layer M10 may be configured to expose the main surfaces of the plurality of chiplet substrate units CS10. For example, the molding layer M10 may expose both surfaces (an upper surface and a lower surface) of each of the plurality of chiplet substrate units CS10.

The number and disposition of the plurality of chiplet substrate units CS10 shown in FIG. 4 are only illustrative and may be varied in various ways. The package substrate S100 may include two or more chiplet substrate units.

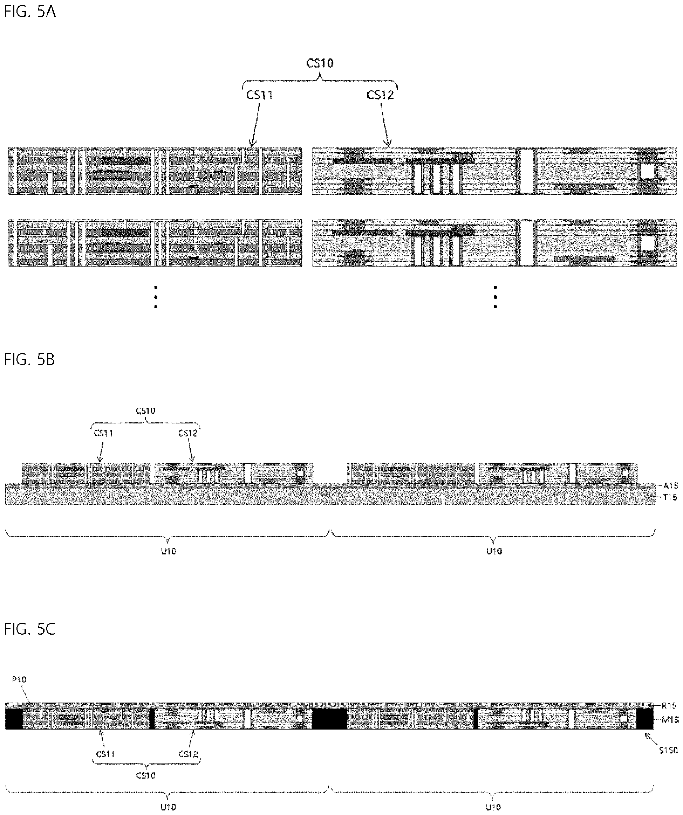

FIGs. 5A to 5F are sectional views illustratively showing a method of manufacturing a semiconductor package device according to an embodiment of the present invention.

Referring to FIG. 5A, a plurality of chiplet substrate units CS10 having different configurations and characteristics may be provided, and the plurality of chiplet substrate units CS10 may be provided in plural in order to constitute a plurality of sets of chiplet substrate units. Each of the plurality of chiplet substrate units CS10 may have a plurality of via-type wiring elements extending in a vertical direction, and may include at least one of one or more passive device elements and one or more active device elements. The plurality of chiplet substrate units CS10 may include first and second chiplet substrate units CS11 and CS12 having different configurations/characteristics. The first chiplet substrate unit CS11 may be provided in plural, and the second chiplet substrate unit CS12 may also be provided in plural.

According to an embodiment, the first and second chiplet substrate units CS11 and CS12 may include different substrate materials or have different circuit configurations. As a specific example, the first chiplet substrate unit CS11 may include an inorganic substrate, and the second chiplet substrate unit CS12 may include an organic substrate (polymer substrate). The inorganic substrate may be a ceramic substrate or a semiconductor substrate. For example, the semiconductor substrate may include any one of a silicon (Si) substrate, a germanium (Ge) substrate, and a silicon germanium (SiGe) substrate, or may include other semiconductor materials. According to another example, the first chiplet substrate unit CS11 may include a first inorganic substrate, and the second chiplet substrate unit CS12 may include a second inorganic substrate, which is different from the first inorganic substrate. Alternatively, the first chiplet substrate unit CS11 may include a first organic substrate, and the second chiplet substrate unit CS12 may include a second organic substrate, which is different from the first organic substrate.

The first chiplet substrate unit CS11 may include at least one embedded passive device element and/or at least one embedded active device element. The second chiplet substrate unit CS12 may include at least one embedded passive device element and/or at least one embedded active device element. As a non-limiting example, the passive device element may include a capacitor, a resistor, an inductor, and an integrated passive device (IPD). As a non-limiting example, the active device element may include a transistor, a diode, an operational amplifier, and an integrated circuit (IC). Both general passive and active devices used in semiconductor devices may be employed. The plurality of chiplet substrate units CS10 may be manufactured according to circuit board manufacturing technology.

Referring to FIG. 5B, the plurality of chiplet substrate units CS10 may be disposed on a carrier substrate T15. In each of a plurality of two-dimensionally disposed unit package areas U10, the plurality of chiplet substrate units CS10 may be disposed spaced apart from each other or adjacent to each other in the horizontal direction. An adhesive layer A15 may be provided on the carrier substrate T15, and the plurality of chiplet substrate units CS10 may be attached to the adhesive layer A15. In other words, the plurality of chiplet substrate units CS10 may be attached to the carrier substrate T15 in the state in which the adhesive layer A15 is interposed therebetween. The carrier substrate T15 may be a panel or a wafer. The adhesive layer A15 may be an adhesive film. The adhesive layer A15 may be a part of the carrier substrate T15.

Referring to FIG. 5C, a molding layer M15 that forms a single substrate shape along with the plurality of chiplet substrate units CS10 while filling the spaces between and around the plurality of chiplet substrate units CS10 may be formed on the carrier substrate T15 (FIG. 5B). The molding layer M15 may include a polymer material. For example, the molding layer M15 may include a molding compound. The plurality of chiplet substrate units CS10 and the molding layer M15 may constitute a package substrate S150. In other words, the package substrate S150 may include a plurality of chiplet substrate units CS10 and a molding layer M15.

Subsequently, a redistribution layer member R15 may be formed on a first surface of the package substrate S150 including the plurality of chiplet substrate units CS10 and the molding layer M15. The first surface of the package substrate S150 may be any one of two main surfaces (an upper surface and a lower surface) of the package substrate S150. The redistribution layer member R15 may serve to redistribute an electrode pad array of the plurality of chiplet substrate units CS10. The redistribution layer member R15 may be formed through processes such as forming an insulating layer having a via hole (opening), forming a seed layer, forming a mask pattern, electroplating a wiring layer, and removing the mask pattern. Although the redistribution layer member R15 is simply shown in FIG. 5C, the redistribution layer member R15 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire.

The redistribution layer member R15 may include a plurality of electrode pads P10 exposed on the surface thereof. The plurality of electrode pads P10 may be disposed on the opposite side of the package substrate S150, and may be disposed in two dimensions. The plurality of electrode pads P10 may be electrically connected to the plurality of chiplet substrate units CS10.

If necessary, the carrier substrate T15 (FIG. 5B) may be removed from the plurality of chiplet substrate units CS10 and the molding layer M15 in this step. At this time, the adhesive layer A15 (FIG. 5B) may also be removed. As a non-limiting example, after forming the molding layer M15, the carrier substrate T15 (FIG. 5B) and the adhesive layer A15 (FIG. 5B) may be removed, and then the redistribution layer member R15 may be formed. The redistribution layer member R15 may be formed on the surface of the package substrate S150 exposed by removing the carrier substrate T15 (FIG. 5B) and the adhesive layer A15 (FIG. 5B). However, this process is only illustrative and may be varied in various ways. The timing of removal of the carrier substrate T15 (FIG. 5B) may vary.

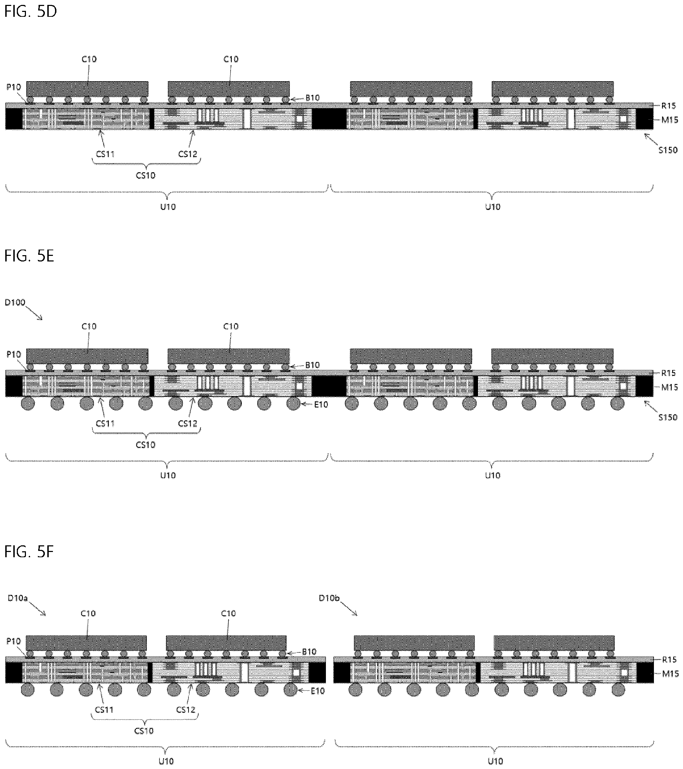

Referring to FIG. 5D, in each of the plurality of unit package areas U10, a plurality of chips C10 may be mounted on the redistribution layer member R15 so as to be electrically connected to the redistribution layer member R15. According to an example, a plurality of bumps B10 may be provided on one surface of each of the plurality of chips C10. In other words, each of the plurality of chips C10 may include a plurality of bumps B10 disposed on one surface thereof. Each of the plurality of bumps B10 may be a micro bump, and may have at least a partial ball shape or other shapes. Each of the plurality of bumps B10 may be a type of electrical connection element. The plurality of chips C10 may be mounted on the redistribution layer member R15 such that the plurality of bumps B10 is electrically connected to the redistribution layer member R15. As the plurality of bumps B10 is connected to the plurality of electrode pads P10, the chip C10 may be electrically connected to the chiplet substrate unit CS10 via the redistribution layer member R15.

According to an embodiment, the plurality of chips C10 may include heterogeneous chips. For example, the plurality of chips C10 may include a memory chip and a logic chip, and may further include other types of chips. In each of the plurality of unit package areas U10, the plurality of chips C10 may be disposed on the redistribution layer member R15 so as to be spaced apart from each other in the horizontal direction, and in some cases, one or more chips (i.e., dies) may be further stacked (mounted) on at least one of the plurality of chips C10.

Referring to FIG. 5E, in each of the plurality of unit package areas U10, a plurality of electrical connection elements E10 may be formed on a second surface of the package substrate S150, which is opposite the first surface of the package substrate S150. The second surface of the package substrate S150 may be any one of the two main surfaces (the upper surface and the lower surface) of the package substrate S150. The plurality of electrical connection elements E10 may be disposed so as to be electrically connected to or to be in electrical contact with the plurality of chiplet substrate units CS10. As a non-limiting example, each of the plurality of electrical connection elements E10 may include a solder ball or a bump.

A device structure D100 including the plurality of chiplet substrate units CS10, the molding layer M15, the redistribution layer member R15, and the plurality of chips C10 may be defined. The device structure D100 may be configured to further include a plurality of electrical connection elements E10. The device structure D100 may include a plurality of package device areas.

Referring to FIG. 5F, the device structure D100 (FIG. 5E) may be divided (cut) into individual package devices corresponding to each of the plurality of unit package areas U10. This may be performed using a general dividing (cutting) method. As a result, it is possible to obtain individual semiconductor package devices D10a and D10b. Each of the semiconductor package devices D10a and D10b may have the same configuration as described with reference to FIG. 1**.**

According to the embodiment of the present invention, the semiconductor package device may be manufactured using a method similar to a fan-out packaging method. For example, the semiconductor package device may be manufactured using a method similar to a fan-out panel level packaging (FOPLP) method or a fan-out wafer level packaging (FOWLP) method. As a specific example, a plurality of chiplet substrate units may be attached to a predetermined carrier substrate, a molding layer configured to fix the plurality of chiplet substrate units may be formed on the carrier substrate, a redistribution layer member electrically connected to the plurality of chiplet substrate units may be formed, and a plurality of chips may be mounted on the redistribution layer member. The plurality of chiplet substrate units may be attached to the carrier substrate, for example, in a face-down manner or a face-up manner. In addition, an RDL-last method or an RDL-first method may be used when manufacturing the semiconductor package device.

According to the embodiment of the present invention described above, it is possible to implement a method of manufacturing a semiconductor package device capable of increasing cost-effectiveness and productivity and improving device performance. In addition, it is possible to provide a method of manufacturing a semiconductor package device that is easy to apply to various designs according to the needs and purposes of users, easy to manufacture, and beneficial for improving performance and a method of manufacturing the same. For example, it is possible to easily improve the performance of the package device, to improve process efficiency, and to improve ease of design change while interconnecting heterogeneous chips using a plurality of chiplet substrate units including embedded passive and active device elements. In addition, it is possible to easily manufacture the semiconductor package device according to the embodiment using a fan-out packaging process including molding and redistribution layer (RDL) processes.

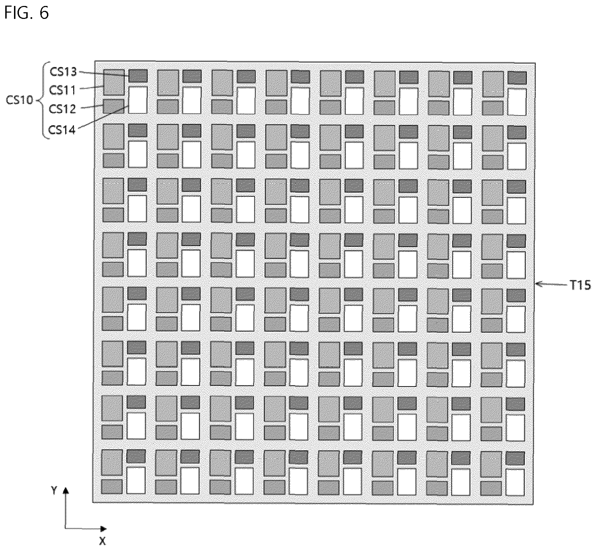

FIG. 6 is a plan view illustratively showing the planar structure of a carrier substrate T15 and a plurality of chiplet substrate units CS10 that can be applied to the method of manufacturing the semiconductor package device according to the embodiment of the present invention. FIG. 6 may correspond to the step of FIG. 5B.

Referring to FIG. 6, the plurality of chiplet substrate units CS10 may be disposed on the carrier substrate T15. In each of a plurality of two-dimensionally disposed unit package areas, the plurality of chiplet substrate units CS10 may be disposed spaced apart from each other or adjacent to each other in the horizontal direction. An adhesive layer (not shown) may be provided on the carrier substrate T15, and the plurality of chiplet substrate units CS10 may be attached to the adhesive layer.

The plurality of chiplet substrate units CS10 may have different configurations and characteristics. In this regard, at least two of the plurality of chiplet substrate units CS10 may include different substrate materials or have different circuit configurations. The plurality of chiplet substrate units CS10 may include, for example, first to fourth chiplet substrate units CS11, CS12, CS13, and CS14. The first to fourth chiplet substrate units CS11, CS12, CS13, and CS14 may have different configurations and characteristics. However, the number and disposition of the plurality of chiplet substrate units CS10 shown in FIG. 6 are only illustrative and may be varied in various ways.

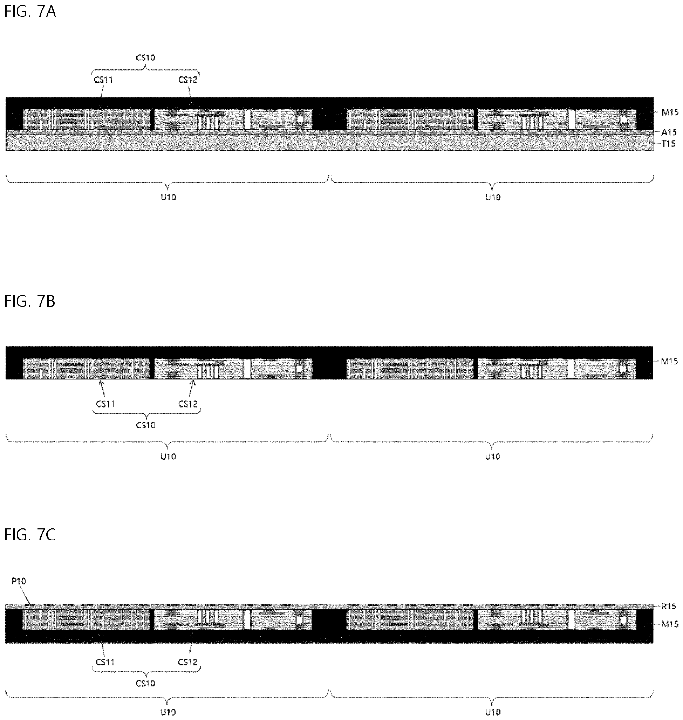

FIGs. 7A to 7D are sectional views illustratively showing a method of manufacturing a semiconductor package device according to another embodiment of the present invention.

Referring to FIG. 7A, a structure as shown in FIG. 5B may be provided. That is, a plurality of chiplet substrate units CS10 may be disposed on a carrier substrate T15, and in each of a plurality of two-dimensionally disposed unit package areas U10, the plurality of chiplet substrate units CS10 may be disposed spaced apart from each other or adjacent to each other in the horizontal direction. An adhesive layer A15 may be provided on the carrier substrate T15, and the plurality of chiplet substrate units CS10 may be attached to the adhesive layer A15.

Subsequently, a molding layer M15 that forms a single substrate shape along with the plurality of chiplet substrate units CS10 while filling the spaces between and around the plurality of chiplet substrate units CS10 may be formed on the carrier substrate T15. The molding layer M15 may be formed on one surface of the carrier substrate T15 so as to cover a plurality of chiplet substrate units CS10. The height of the molding layer M15 may be greater than the height of the chiplet substrate units CS10. In other words, the molding layer M15 may be formed with a thickness greater than the thickness of the chiplet substrate units CS10 so as to cover the plurality of chiplet substrate units CS10. Consequently, the upper surface of the chiplet substrate units CS10 may be covered with the molding layer M15. The molding layer M15 in this step may be referred to as an initial molding layer.

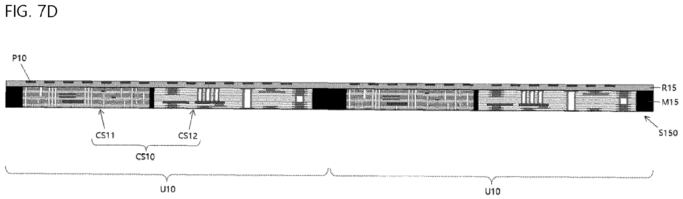

Referring to FIG. 7B, the carrier substrate T15 (FIG. 7D) and the adhesive layer A15 (FIG. 7D) may be removed (separated) from the plurality of chiplet substrate units CS10 and the molding layer M15.

Referring to FIG. 7C, a redistribution layer member R15 may be formed on a first surface of a package substrate including the plurality of chiplet substrate units CS10 and the molding layer M15. For example, the redistribution layer member R15 may be formed on the surface of the package substrate exposed by removing the carrier substrate T15 (FIG. 7D) and the adhesive layer A15 (FIG. 7D). FIG. 7C shows the case where the redistribution layer member R15 is formed in the state in which the structure of FIG. 7B is flipped upside down for convenience.

Referring to FIG. 7D, a grinding or ablation process may be performed on the molding layer M15 to expose one surface of each of the plurality of chiplet substrate units CS10. As a result, the surface of the molding layer M15 and the surface of the chiplet substrate unit CS10 may form the same (substantially the same) plane.

The structure of FIG. 7D may be the same as the structure of FIG. 5C. Subsequently, the same method as previously described with reference to FIGs. 5D to 5F may applied to the structure of FIG. 7D to manufacture the semiconductor package device. However, the method of manufacturing the semiconductor package device according to the embodiment described with reference to FIGs. 5A to 5F, 6, and 7A to 7D may be varied as needed.

According to embodiments of the present invention, it is possible to implement a semiconductor package device capable of increasing cost-effectiveness and productivity and improving device performance and a method of manufacturing the same. In addition, according to embodiments of the present invention, it is possible to provide a semiconductor package device that is easy to apply to various designs according to the needs and purposes of users, easy to manufacture, and beneficial for improving performance and a method of manufacturing the same.

According to an embodiment, for example, it is possible to easily improve the performance of the package device, to improve process efficiency, and to improve ease of design change while interconnecting heterogeneous chips using a plurality of chiplet substrate units including embedded passive and active device elements. According to an embodiment, for example, it is possible to easily manufacture the semiconductor package device according to the embodiment using a fan-out packaging process including molding and redistribution layer (RDL) processes. Technology according to the embodiments may be usefully applied to various advanced packaging fields.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the semiconductor package device and the method of manufacturing the same according to the embodiments described with reference to FIGs. 1 to 7D may be subject to various substitutions, changes, and modifications without departing from the technical ideas of the present invention. The scope of the invention is therefore not to be defined by the embodiments described above but by the technical ideas recited in the appended claims.

## Claims

1. A semiconductor package device comprising:
a plurality of chiplet substrate units having different configurations and characteristics, the plurality of chiplet substrate units being disposed spaced apart from each other or adjacent to each other in a horizontal direction, each of the plurality of chiplet substrate units having a plurality of via-type wiring elements extending in a vertical direction, each of the plurality of chiplet substrate units comprising at least one of one or more passive device elements and one or more active device elements;
a molding layer configured to form a single substrate shape along with the plurality of chiplet substrate units while filling spaces between and around the plurality of chiplet substrate units and to expose the plurality of chiplet substrate units;
a redistribution layer member disposed on a first surface of a package substrate comprising the plurality of chiplet substrate units and the molding layer; and
a plurality of chips mounted on the redistribution layer member so as to be electrically connected to the redistribution layer member.

2. The semiconductor package device according to claim 1, wherein
the plurality of chiplet substrate units comprises a first chiplet substrate unit and a second chiplet substrate unit, and
the first chiplet substrate unit and the second chiplet substrate unit comprise different substrate materials or have different circuit configurations.

3. The semiconductor package device according to claim 2, wherein
the first chiplet substrate unit comprises an inorganic substrate, and
the second chiplet substrate unit comprises an organic substrate.

4. The semiconductor package device according to claim 2, wherein the plurality of chiplet substrate units further comprises one or more additional chiplet substrate units having different configurations from the first chiplet substrate unit and the second chiplet substrate unit.

5. The semiconductor package device according to claim 1, wherein
the plurality of chiplet substrate units comprises a first chiplet substrate unit and a second chiplet substrate unit,
the first chiplet substrate unit comprises at least one embedded passive device element and at least one embedded active device element, and
the second chiplet substrate unit comprises at least one embedded passive device element and at least one embedded active device element.

6. The semiconductor package device according to claim **1,** wherein
a plurality of bumps is provided on one surface of each of the plurality of chips, and
the plurality of chips is mounted on the redistribution layer member such that the plurality of bumps is electrically connected to the redistribution layer member.

7. The semiconductor package device according to claim 1, wherein the plurality of chips comprises heterogeneous chips.

8. The semiconductor package device according to claim 1, wherein a plurality of electrical connection elements is disposed on a second surface of the package substrate, the second surface being opposite the first surface.

9. The semiconductor package device according to claim 8, wherein each of the plurality of electrical connection elements comprises a solder ball or a bump.

10. A method of manufacturing a semiconductor package device, the method comprising:
providing a plurality of chiplet substrate units having different configurations and characteristics, each of the plurality of chiplet substrate units having a plurality of via-type wiring elements extending in a vertical direction, each of the plurality of chiplet substrate units comprising at least one of one or more passive device elements and one or more active device elements, the plurality of chiplet substrate units being provided in plural in order to constitute a plurality of sets of chiplet substrate units;
disposing the plurality of chiplet substrate units on a carrier substrate, the plurality of chiplet substrate units being disposed spaced apart from each other or adjacent to each other in a horizontal direction in each of a plurality of two-dimensionally disposed unit package areas;
forming a molding layer configured to form a single substrate shape along with the plurality of chiplet substrate units while filling spaces between and around the plurality of chiplet substrate units on the carrier substrate;
forming a redistribution layer member on a first surface of a package substrate comprising the plurality of chiplet substrate units and the molding layer;
mounting a plurality of chips on the redistribution layer member so as to be electrically connected to the redistribution layer member in each of the plurality of unit package areas; and
dividing a device structure comprising the plurality of chiplet substrate units, the molding layer, the redistribution layer member, and the plurality of chips, with the carrier substrate being excluded, into individual package devices corresponding to each of the plurality of unit package areas.

11. The method according to claim 10, wherein
the plurality of chiplet substrate units comprises a first chiplet substrate unit and a second chiplet substrate unit, and
the first chiplet substrate unit and the second chiplet substrate unit comprise different substrate materials or have different circuit configurations.

12. The method according to claim 10, further comprising forming a plurality of electrical connection elements on a second surface of the package substrate in each of the plurality of unit package areas, the second surface being opposite the first surface.

13. The method according to claim 12, wherein each of the plurality of electrical connection elements comprises a solder ball or a bump.

14. The method according to claim 10, further comprising removing the carrier substrate from the plurality of chiplet substrate units and the molding layer between the step of forming the molding layer and the step of dividing the device structure into the individual package devices.

15. The method according to claim 10, further comprising:
forming an initial molding layer configured to cover the plurality of chiplet substrate units; and
performing a grinding or ablation process on the initial molding layer to expose one surface of each of the plurality of chiplet substrate units.
